# EUROPEAN PATENT APPLICATION

(11) **EP 1 143 495 A1**
(43) Date of publication of application: **10.10.2001**
(21) Application number: 00961028.8
(22) Date of filing: 14.09.2000
(51) Int. Cl.: H01L 21/26

(54) **SEMICONDUCTOR MANUFACTURING DEVICE, AND METHOD OF HEATING WAFER IN SEMICONDUCTOR MANUFACTURING DEVICE**

(30) Priority: 17.09.1999 JP 26408599
(71) Applicant: Applied Materials, Inc., Santa Clara, California 95054 (US)
(72) Inventor: KAWAI, Ichiro, Narita-shi, Chiba 286-8516 (JP); MAEDA, Yuji, Narita-shi, Chiba 286-8516 (JP)
(74) Representative: Draper, Martyn John
(86) International application number: JP0006318
(87) International publication number: WO0122483

(57) **Abstract**

When carrying out heat treatment of a wafer (substrate) by a heat treatment apparatus, the wafer is initially transferred into a process chamber so as to be held by a substrate supporting member. Subsequently, a process gas is supplied to a space on the wafer surface side within the process chamber, and an oxygen-containing gas is supplied to a closed space on the back side of wafer. Also, while the wafer is rotated, a plurality of heating lamps are lit. Then, the temperature of the wafer rises and, when it reaches a predetermined temperature, an oxidized film SiO₂ is formed on the back face of the wafer. Consequently, the external diffusion from the back face of the wafer such as the sublimation of SiO or occurrence of phosphorus is reduced. Therefore, the stability in temperature measurement can be maintained.

## Description

### Technical Field

The present invention relates to a substrate heating method for heating a substrate in a semiconductor fabrication apparatus, and a semiconductor fabrication apparatus.

### Background Art

A heat treatment apparatus, which is one of semiconductor fabrication apparatus, comprises a process chamber, a rotatable substrate supporting member installed within the process chamber so as to support a semiconductor wafer (substrate), a heating lamp for heating the semiconductor wafer supported by the substrate supporting member, and a temperature sensor for detecting the temperature of semiconductor wafer, for example. In the case where heat treatment of a semiconductor wafer is carried out by such a heat treatment apparatus, a process gas is supplied into the process chamber after the semiconductor wafer is supported by the substrate supporting member. With the substrate being rotated, the semiconductor wafer is heated to a predetermined temperature by the heating lamp while the temperature of semiconductor wafer is being monitored by the temperature sensor.

In the above-mentioned heat treatment apparatus, however, the temperature reproducibility in heat treatment conditions may deteriorate when the stability in temperature measurement lowers, thereby degrading the stability of process.

It is an object of the present invention to provide a substrate heating method in a semiconductor fabrication apparatus and a semiconductor fabrication apparatus, which can maintain the stability in temperature measurement.

### Disclosure of the Invention

The inventors carried out diligent studies and, as a result, have found that, when a substrate is heat-treated, external diffusion occurs from the substrate, and the stability in temperature measurement deteriorates when thus diffused material attaches to or deposits on a measurement terminal part of a temperature sensor. As a result of further studies, the inventors have found that, when a substrate is heat-treated, dopants of phosphorus, arsenic, boron, and the like which are added to the substrate for controlling the resistance of substrate may occur, and a suboxide of silicon (SiO), which is a naturally oxidized film formed on a surface of the substrate, may sublime. Hence, based on such finding, the present invention has been completed.

Namely, the present invention provides a substrate heating method in a semiconductor fabrication apparatus comprising a process chamber, a substrate supporting member installed within the process chamber so as to support a substrate, and a heating member for heating the substrate supported by the substrate supporting member, a substantially closed space being formed on the back side of the substrate when the substrate is supported by the substrate supporting member; the method including a step of supplying a first gas to the outside of the closed space within the process chamber after the substrate is supported by the substrate supporting member, a step of supplying a second gas containing a modified layer forming gas for forming a modified layer on the back face of the substrate into the closed space after the substrate is supported by the substrate supporting member, and a step of causing the heating member to heat the substrate supported by the substrate supporting member.

The above-mentioned semiconductor fabrication apparatus is preferably configured such that the closed space is maintained in a substantially closed state due to the self weight of the substrate or the like when the substrate is supported by the substrate supporting member even if the inside of the closed space is pressurized. As a consequence, the second gas containing the modified layer forming gas can be restrained from leaking from within the closed space, and the leakage, if any, can be minimized.

When the second gas containing the modified layer forming gas is supplied into the closed space as such, a modified layer is formed on the back face of the substrate, which suppresses the external diffusion from the back face of the substrate such as the sublimation of SiO. Also, the modified layer makes it hard for dopants of phosphorus and the like added to the substrate to externally diffuse from the back face of the substrate. Therefore, the amount of diffused material occurring from the back face of the substrate is reduced, whereby the stability in temperature measurement can be maintained.

Preferably, when supplying the second gas into the closed space, the second gas is supplied such that the flow rate of the second gas supplied into the closed space is lower than the flow rate of the gas discharged from within the closed space. As a consequence, a part of the first gas supplied to the outside of the closed space within the process chamber is drawn into the closed space by way of a slight gap formed between the substrate and the substrate supporting member, and the like. Therefore, the modified layer forming gas supplied into the closed space is prevented from making a detour to the surface side of the substrate.

Preferably, when supplying the second gas into the closed space, the flow rate of the gas discharged from within the closed space is detected, and the difference between the flow rate of the gas discharged from within the closed space and the flow rate of the second gas supplied into the closed space is adjusted so as to fall within a predetermined range. As a consequence, even when the flow rate of the gas discharged from within the closed space fluctuates for some reason, adjusting the flow rate of the second gas supplied into the closed space as mentioned above prevents the modified layer forming gas from making a detour to the surface side of the substrate.

Preferably, the concentration of the modified layer forming gas in the gas discharged from within the closed space is detected, and the heating of the substrate is stopped when the concentration of the modified layer forming gas does not fall within a predetermined range. This prevents the modified layer forming gas from making a detour to the surface side of the substrate and thereby adversely affecting the surface processing of the substrate, and the thickness of the modified layer formed on the back face of the substrate from becoming insufficient.

Also, the concentration of the modified layer forming gas in the gas discharged from outside the closed space within the process chamber may be detected, and the heating of the substrate may be stopped when the concentration of the modified layer forming gas exceeds a predetermined value. As a consequence, the modified layer forming gas is prevented from adversely affecting the surface processing of the substrate.

Preferably, O₂ gas is used as the modified layer forming gas, and an oxidized layer is formed as the modified layer. Formed on the back face of the substrate in this case is SiO₂ which is an oxidized film capable of preventing SiO from subliming.

Also, one of NH₃ gas, NO gas, and N₂O gas may be used as the modified layer forming gas, so as to form a nitride film or oxynitride film as the modified layer. For example, when NH₃ gas is used as the modified layer forming gas, Si₃N₄ is formed on the back face of the substrate.

Preferably, a gas containing the modified layer forming gas and the first gas is used as the second gas. This minimizes the gases used, thereby lowering the cost.

A gas containing the modified layer forming gas and N₂ gas may be used as the second gas. This lowers the cost of the second gas.

For example, the semiconductor fabrication apparatus is a heat treatment apparatus. In this case, the heat treatment process by the heat treatment apparatus can be carried out stably.

Also, the present invention provides a substrate heating method in a semiconductor fabrication apparatus comprising a process chamber, a substrate supporting member installed within the process chamber so as to support a substrate, heating means for heating the substrate supported by the substrate supporting member, and sensor means for detecting a temperature of the substrate by utilizing a substantially closed space formed on the back side of the substrate when the substrate is supported by the substrate supporting member; the method including a step of forming the closed space by causing the substrate supporting member to support the substrate introduced into the process chamber, and a step of supplying a gas containing a modified layer forming gas for forming a modified layer on the back face of the substrate into the closed space. This reduces the amount of diffused material occurring from the back face of the substrate as mentioned above, whereby the stability in temperature measurement can be maintained.

The present invention also provides a semiconductor fabrication apparatus comprising a process chamber, a substrate supporting member installed within the process chamber so as to support a substrate, and heating means for heating the substrate supported by the substrate supporting member, a substantially closed space being formed on the back side of the substrate when the substrate is supported by the substrate supporting member; the apparatus comprising first gas supplying means for supplying a first gas to the outside of the closed space within the process chamber, and second gas supplying means for supplying a second gas containing a modified layer forming gas for forming a modified layer on the back face of the substrate into the closed space.

Providing the second gas supplying means as such can form a modified layer on the back face of the substrate. Consequently, as mentioned above, external diffusion such as the sublimation of SiO or the occurrence of phosphorus or the like from the back face of the substrate is reduced as mentioned above, whereby the stability in temperature measurement can be maintained.

Preferably, the second gas supplying means has valve means for adjusting the flow rate of the gas discharged from within the closed space. As a consequence, adjusting the valve means such that the flow rate of the second gas supplied into the closed space is lower than the flow rate of the gas discharged from within the closed space, for example, can prevent the modified layer forming gas from making a detour to the surface side of the substrate.

Preferably, the second gas supplying means has supply flow rate control means for controlling the flow rate of the second gas supplied into the closed space. In this case, when the supply flow rate control means is operated, the flow rate of the second gas supplied into the closed space can be made smaller than the flow rate of the gas discharged from within the closed space.

Preferably, flow rate detecting means for detecting the flow rate of the gas discharged from within the closed space, and means for controlling the supply flow rate control means according to a value detected by the flow rate detecting means such that the difference between the flow rate of the gas discharged from within the closed space and the flow rate of the second gas supplied into the closed space falls within a predetermined range are further provided. As a consequence, even when the flow rate of the gas discharged from within the closed space fluctuates for some reason, the modified layer forming gas is prevented from making a detour to the surface side of the substrate. Also, since the supply flow rate of the second gas is automatically controlled so as to become a desirable flow rate, the burden on operators is alleviated.

Preferably, in this case, the second gas supplying means has a first open/close valve for turning on/off the flow of the gas discharged from within the closed space; a second open/close valve, connected in parallel with the first open/close valve, for turning on/off the flow of the gas discharged from within the closed space, the flow rate detecting means being connected in parallel with the first open/close valve on the downstream side of the second open/close valve. Usually, in this case, the first open/close valve is opened while the second open/close valve is closed, so as to discharge the gas from within the closed space by way of the first open/close valve. Only when it is necessary to adjust the supply flow rate of the second gas, the first open/close valve is closed while the second open/close valve is opened, so as to discharge the gas from within the closed space by way of the second open/close valve. As a consequence, the life of instruments provided in the gas discharge system for the second gas supplying means is elongated.

Preferably, in this case, setting means for setting the opening/closing of the first and second open/close valves such that one of the first and second open/close valves is in an open state when the other is in a closed state is further provided. This makes it unnecessary to operate both of the first and second open/close valves each time, whereby the burden on operators is alleviated.

Preferably, further provided are means for detecting the concentration of the modified layer forming gas in the gas discharged from within the closed space, and means for determining according to thus detected value whether the concentration of the modified layer forming gas is within a predetermined range or not and, when it is determined that the concentration is not within the predetermined range, outputting a process stop signal. In this case, when the process stop signal is outputted, at least the supply of second gas is stopped, or the heating of the substrate by the heating means is stopped. This prevents the modified layer forming gas from making a detour to the surface side of the substrate and thereby adversely affecting the surface processing of the substrate, and the thickness of the modified layer formed on the back face of the substrate from becoming insufficient.

Also, means for detecting the concentration of the modified layer forming gas in the gas discharged from outside the closed space within the process chamber, and means for determining according to thus detected value whether the concentration of the modified layer forming gas exceeds a predetermined value or not and, when it is determined that the concentration exceeds the predetermined value, outputting a process stop signal may further be provided. In this case, when the process stop signal is outputted, at least the supply of second gas is stopped, or the heating of the substrate by the heating means is stopped. This prevents the modified layer forming gas from adversely affecting the surface processing of the substrate.

Preferably, display means for displaying a processing state is further provided. As a consequence, when the above-mentioned process stop signal is outputted to the display means, operators can look at the display means and grasp that the process is stopped.

Preferably, the process chamber has a base section forming a part of the closed space and having a sensor installation region in which a sensor is installed; the second gas supplying means has a gas inlet, disposed in the base section, for supplying the second gas into the closed space, and a gas outlet, disposed in the base section, for discharging the second gas from within the closed space; and the sensor installation region is disposed between the gas inlet and the gas outlet. As a consequence, even when a blockage exists at the upper end portion of the sensor installed in the base section, the blockage is discharged from the gas outlet together with the second gas. Therefore, the stability in the measurement by the sensor is secured.

The present invention also provides a semiconductor fabrication apparatus comprising a process chamber, a substrate supporting member installed within the process chamber so as to support a substrate, heating means for heating the substrate supported by the substrate supporting member, sensor means for detecting a temperature of the substrate by utilizing a substantially closed space formed on the back side of the substrate when the substrate is supported by the substrate supporting member, and gas supplying means for supplying a gas containing a modified layer forming gas for forming a modified layer on the back face of the substrate into the closed space. Consequently, the amount of diffused material occurring from the back face of the substrate is reduced as mentioned above, whereby the stability in temperature measurement can be maintained.

### Brief Description of the Drawings

Fig. 1 is a perspective view showing a partial cross section of a heat treatment apparatus as an embodiment of the semiconductor fabrication apparatus in accordance with the present invention;
Fig. 2 is a sectional view showing a part including a process chamber in the heat treatment apparatus shown in Fig. 1;
Fig. 3 is a block diagram of a gas supply system in the heat treatment apparatus shown in Fig. 1;
Fig. 4 is a diagram showing control functions of the control unit shown in Fig. 3;
Fig. 5 is a time chart showing the relationship between an operation sequence for carrying out heat treatment by using the heat treatment apparatus shown in Fig. 1 and the wafer temperature;
Fig. 6 is a graph showing an example of the relationships between the oxygen concentration in the gas within the closed space on the back side of wafer and the phosphorus concentration within the wafer and the film thickness of the oxidized film SiO₂ formed on the back face of the wafer;
Fig. 7 is a graph showing an example of the relationship between the oxygen concentration in the gas within the closed space on the back side of wafer and the oxygen concentration of the gas within the space on the wafer surface side;
Fig. 8A is a graph showing an example of sheet resistance characteristic of wafers and its uniformity characteristic when no oxygen gas is added into the closed space on the back side of wafer at the time of heat treatment;
Fig. 8B is a graph showing an example of sheet resistance characteristic of wafer and its uniformity characteristic when oxygen gas is added into the closed space on the back side of wafer at the time of heat treatment; and
Fig . 9 is a graph showing an example of sheet resistance characteristic of wafers and its uniformity characteristic when 1000 sheets of wafers are heat-treated in a state where oxygen gas is added into the closed space on the back side of wafer.

### Best Modes for Carrying Out the Invention

In the following, a preferred embodiment of the semiconductor fabrication apparatus in accordance with the present invention will be explained with reference to the drawings.

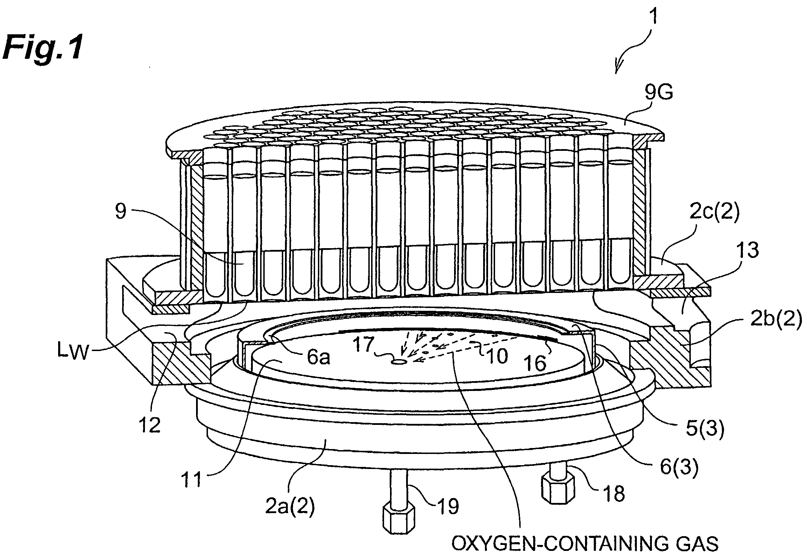

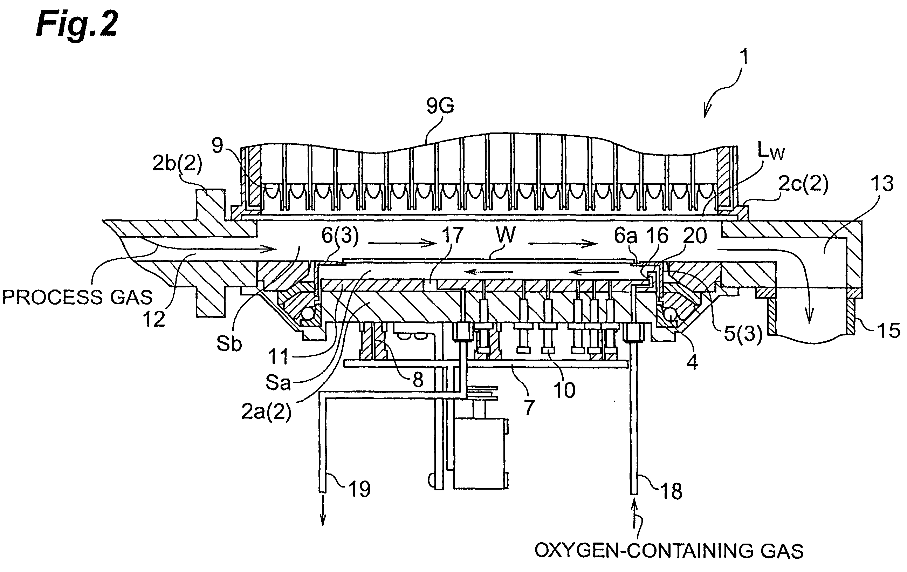

Fig. 1 is a perspective view showing a partial cross section of a heat treatment apparatus as an embodiment of the semiconductor fabrication apparatus in accordance with the present invention. Fig. 2 is an enlarged sectional view showing a part of the heat treatment apparatus. In these drawings, a heat treatment apparatus 1 is a single-wafer-processing rapid-heating heat treatment apparatus which carries out heat treatment while controlling the temperature of a silicon wafer (substrate) W. The heat treatment apparatus 1 comprises a process chamber 2 constituted by a base section 2a, a side wall section 2b, and a lid section 2c.

Installed within the process chamber 2 is a substrate supporting member 3 for supporting the wafer W. The substrate supporting member 3 is constituted by a cylindrical frame 5 rotatably attached to the base section 2a by way of a bearing 4, and a ring frame 6 disposed at the upper end of the cylindrical frame 5. An inner edge portion of the ring frame 6 is formed with a supporting stage 6a for supporting an edge portion of the wafer W. Here, in the state where the wafer W is supported by the substrate supporting member 3 (Fig. 2), a closed space (hereinafter referred to as the closed space on the back side of wafer) Sa surrounded by the base section 2a, the substrate supporting member 3, and the wafer W is formed. When the edge portion of the wafer W is mounted on the supporting stage 6a of the ring frame 6, a slight gap may occur between the wafer W and the ring frame 6 due to their structures.

The lower part of the base section 2a is provided with a lift member 7 for supporting the wafer W, which is transferred into the process chamber 2 by a transfer robot (not depicted), at the substrate supporting member 3. The lift member 7 has a plurality of (e.g., 3) support pins 8 penetrating through the base section 2 so as to raise the wafer W.

Disposed above the lid section 2c of the process chamber 2 is a lamp group 9G comprising a plurality of heating lamps (heating member) 9 for heating the wafer W supported by the substrate supporting member 3. The lid section 2c is provided with a circular lamp window portion Lw, through which the heat of heating lamps 9 is transmitted to the wafer W. The base section 2a is provided with temperature sensors (sensor means) 10 for optically detecting the temperature of the wafer W. In a circular plate 11 surrounded by the substrate supporting member 3 in the base section 2a, a plurality of temperature sensors 10 are built within a substantially sector-shaped sensor installation region including the center and a part of the circumference of the circular plate 11 and having a predetermined angle (e.g., 90 degrees) . The closed space Sa on the back side of wafer is optically a completely closed space, whereby the optical temperature sensors 10 can detect the temperature of the wafer W by utilizing the closed space Sa without difficulty.

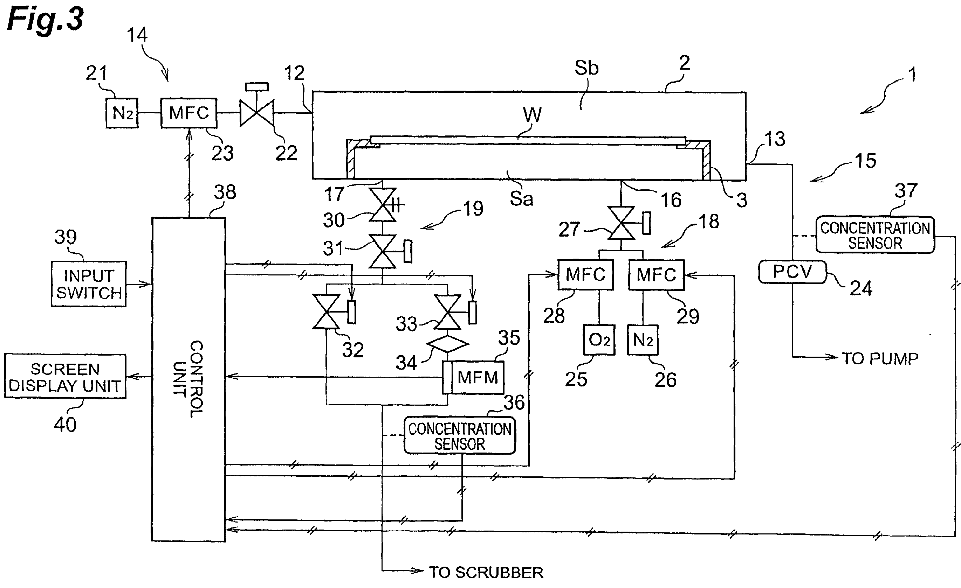

The side wall section 2b of the process chamber 2 is provided with a gas inlet 12 and a gas outlet 13 opposing each other. Connected to the gas inlet 12 is a gas supply system 14 (see Fig. 3) for supplying a process gas (first gas) to the outside (hereinafter referred to as the space on the wafer surface side) Sb of the space Sa on the back side of wafer within the process chamber 2. Connected to the gas outlet 13 is a gas discharge system 15 (see Fig. 3) for discharging the gas within the space Sb on the wafer surface side to the outside of the process chamber 2. The process gas is a gas used for the process, and nitrogen gas (N₂ gas) is used here.

The circular plate 11 of the base section 2a is provided with a gas inlet 16 and a gas outlet 17. Connected to the gas inlet 16 is a gas supply system 18 for supplying a gas (second gas) containing a modified layer forming gas for forming a modified layer into the closed space Sa on the back side of wafer. Connected to the gas outlet 17 is a gas discharge system 19 for discharging the gas within the closed space Sa on the back side of wafer to the outside of the process chamber 2.

Here, as the modified layer forming gas, oxygen gas (O₂ gas) for forming a modified layer (chemical protective film) of silicon dioxide SiO₂ on the back face of the wafer W is used. As the gas containing the modified layer forming gas, a mixed gas of O₂ gas and N₂ gas (hereinafter referred to as oxygen-containing gas) is used. When a gas containing N₂ gas identical to the process gas is thus employed as the oxygen-containing gas, the oxygen concentration for forming the modified film onto the back face of the wafer W can be kept at a minimum level. Also, the damage occurring upon the leakage to the surface side of the wafer W is minimized. Further, since only two kinds of gases are used in this process, the cost can be lowered.

A lug 20 having an L-shaped cross section is disposed at a part including the sensor installation region in the circumference of the circular plate 11, whereas the gas inlet 16 is formed inside the lug 20. The gas outlet 17 is formed in the circular plate 11 at a position slightly deviating from its center to the opposite side of the gas inlet 16, such that the sensor installation region is disposed between the gas inlet 16 and the gas outlet 17. As a consequence, the oxygen-containing gas introduced from the gas inlet 16 is discharged from the gas outlet 17 by way of the area above the whole sensor installation region in the circular plate 11.

Here, the gas inlet 12, gas outlet 13, gas supply system 14, and gas discharge system 15 constitute a first gas supplying means for supplying the first gas (process gas) to the outside (the space on the wafer surface side) Sb of the closed space (the closed space on the back side of wafer) Sa within the process chamber 2. The gas inlet 16, gas outlet 17, gas supply system 18, and gas discharge system 19 constitute a second gas supplying means for supplying the second gas (oxygen-containing gas) containing a modified layer forming gas for forming a modified layer on the back face of the substrate W into the closed space Sa.

Fig. 3 shows a block diagram of the above-mentioned supply systems for the process gas and oxygen-containing gas. In this diagram, the gas supply system 14 has a nitrogen supply source 21; an air valve 22, disposed between the nitrogen gas supply source 21 and the gas inlet 12 of the process chamber 2, for turning on/off the flow of process gas supplied from the nitrogen gas supply source 21 into the space Sb on the wafer surface side; and a mass-flow controller (supply flow rate control means, hereinafter referred to as MFC) 23 for controlling the flow rate of the process gas supplied into the space Sb on the wafer surface side. The gas discharge system 15 has a pressure control valve (PCV) 24 connected to the gas outlet 13 of the process chamber 2, whereas an exhaust pump is connected to the secondary side of the PCV 24.

The gas supply system 18 has an oxygen supply source 25 and a nitrogen gas supply source 26; an air valve 27, disposed between the gas inlet 16 of the process chamber 2 and the gas supply sources 25, 26, for turning on/off the flow of oxygen-containing gas supplied from the gas supply sources 25, 26 into the closed space Sa on the back side of wafer; and MFCs 28, 29 for controlling the flow rates of O₂ gas and N₂ gas supplied into the closed space Sa on the back side of wafer.

The gas discharge system 19 has a needle valve 30, connected to the gas outlet 17 of the process chamber 2, for adjusting the flow rate of the gas discharged from within the closed space Sa on the back side of wafer to the outside of the process chamber 2; a main air valve 31, connected to the secondary side of the needle valve 30, for turning on/off the flow of the gas discharged from within the closed space Sa on the back side of wafer; an auxiliary air valve 32 (first open/close valve) and an auxiliary air valve 33 (second open/close valve) which are connected in parallel with the secondary side of the main air valve 31; and a mass-flow meter (flow rate detecting means, hereinafter referred to as MFM) 35, connected to the secondary side of the auxiliary air valve 33 by way of a filter 34, for detecting the flow rate of the gas discharged from within the space Sa on the back side of wafer. The downstream side of the auxiliary air valve 32 and MFM 35 is connected to a scrubber, whereby the gas discharged from within the space Sa on the back side of wafer is sent to the scrubber. The filter 34 is disposed between the auxiliary air valve 33 and the MFM 35 in order to prevent particles and the like contained in the gas from entering and blocking the MFM 35.

The gas discharge path between the scrubber and the auxiliary air valve 32 and MFM 35 is provided with a concentration sensor for detecting the oxygen concentration in the gas discharged from within the space Sa on the back side of wafer. The gas discharge path between the gas outlet 13 of the process chamber 2 and the PCV 24 is provided with a concentration sensor 37 for detecting the oxygen concentration in the gas discharged from within the space Sb on the wafer surface side.

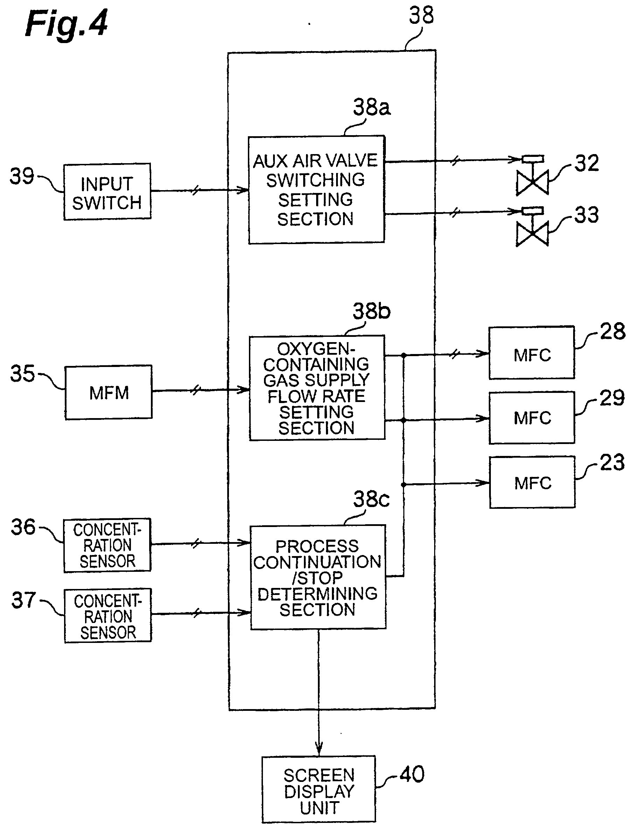

The values detected by the above-mentioned MFM 35 and concentration sensors 36, 37 are sent as electric signals to a control unit 38. Connected to the control unit 38 are an on/off input switch 39 for switching the opening/closing of the auxiliary air valves 32, 33, and a screen display unit (display means) 40 for displaying the current processing state onto a screen. The control unit 38 inputs the respective signals detected by the MFM 35 and concentration sensors 36, 37 and the signal instructed by the input switch 39, carries out a predetermined processing operation, and outputs the result of processing as electric signals to the MFCs 23, 28, 29, auxiliary air valves 32, 33, and the screen display unit 40. The MFC 23 is controlled by the control unit 38 so as to be always in its ON state unless there are some instructions. Though not shown in Fig. 3, the control unit 38 functions to control a plurality of heating lamps 9 according to the values detected by a plurality of temperature sensors 10, so as to carry out temperature control of the wafer W. Fig. 4 shows details of such processing functions of the control unit 38.

In Fig. 4, the control unit 38 has an auxiliary air valve switching setting section 38a, an oxygen-containing gas supply flow rate setting section 38b, and a process continuation/stop determining section 38c. The auxiliary air valve switching setting section 38a inputs the instruction signal from the input switch 39 and, when the instruction signal is OFF, outputs to the auxiliary air valves 32, 33 such setting signals that the auxiliary air valves 32 and 33 attain open and closed states, respectively. If the instruction signal is ON, by contrast, then the auxiliary air valve switching setting section 38a outputs to the auxiliary air valves 32, 33 such setting signals that the auxiliary air valves 32 and 33 attain closed and open states, respectively. Since the opening and closing of the auxiliary air valves 32, 33 are automatically switched when the input switch 39 is simply turned on/off as such, it is not necessary for operators to manually operate both of the auxiliary air valves 32, 33, whereby the burden on operators is alleviated.

The oxygen-containing gas supply flow rate setting section 38b controls the MFCs 28, 29 according to the value detected by the MFM 35, thereby regulating the flow rates of O₂ gas and N₂ gas supplied into the closed space Sa on the back side of wafer. Here, the oxygen-containing gas supply flow rate setting section 38b generates a setting signal for causing the difference between the flow rate of the oxygen-containing gas supplied into the closed space Sa on the back side of wafer and the flow rate of the gas discharged from within the closed space Sa on the back side of wafer to become a predetermined value, and sends this signal to the MFCs 28, 29. Instead of the control unit 38, the MFM 35 or MFCs 28, 29 may be provided with the above-mentioned functions of the oxygen-containing gas supply flow rate setting section 38b.

The process continuation/stop determining section 38c inputs the respective values detected by the concentration sensors 36, 37 and determines whether the oxygen concentration in the gas discharged from within the closed space Sa on the back side of wafer and the oxygen concentration in the gas discharged from within the space Sb on the wafer surface side fall within their predetermined standards or not. Then, at the point in time when the oxygen concentration in the gas discharged from within the closed space Sa on the back side of wafer deviates from its corresponding standard or at the point in time when the oxygen concentration in the gas discharged from within the space Sb on the wafer surface side exceeds its corresponding standard, the process continuation/stop determining section 38c outputs a process stop signal to the MFCS 28, 29. As a consequence, the supply of oxygen-containing gas into the process chamber 2 stops, thereby interrupting the process for heating the wafer W. The above-mentioned process stop signal may be sent to each heating lamp 9, so as to turn off the output of all the heating lamps 9. Also, the process continuation/stop determining section 38c outputs the process stop signal to the screen display unit 40, so as to cause the screen display unit 40 to display process stop information, and generates an alarm as occasion arises. Hence, by seeing the screen display unit 40 or hearing an audible alarm, operators can notice that the process is stopped.

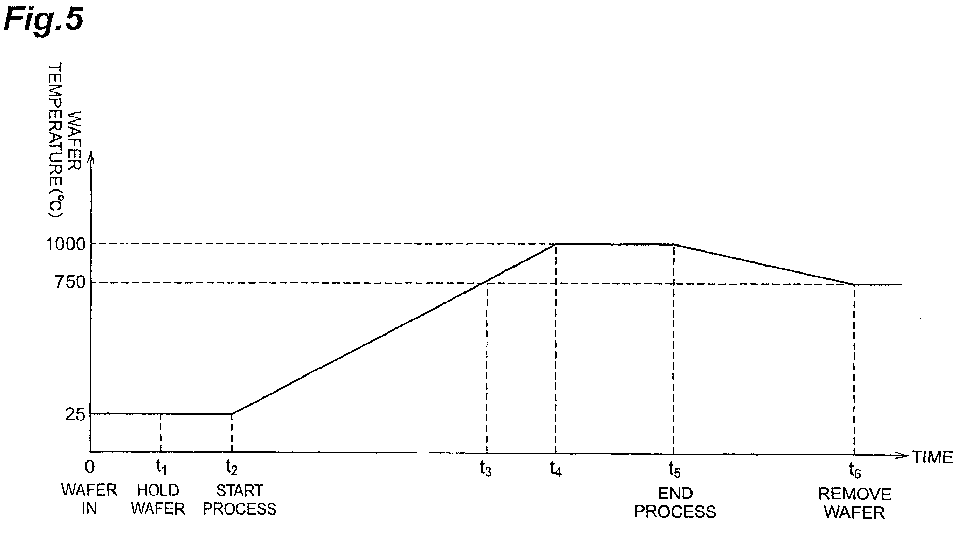

The procedure of heat-treating wafers W sheet by sheet by using the heat treatment apparatus 1 configured as in the foregoing will now be explained with reference to the time chart of Fig. 5. First, before carrying out this process, a wafer W for adjustment is supported by the substrate supporting member 3, a closed space Sa on the back side of wafer and a space Sb on the wafer surface side are formed within the process chamber 2, and the initial adjustment of gas flow rate is carried out. Here, when the wafer W is supported by the substrate supporting member 3, the inside of the closed space Sa on the back side of wafer is kept in a substantially closed state due to the self weight of the wafer W even if the inside of the closed space Sa on the back side of wafer is pressurized. The substrate supporting member 3 may be provided with a member for clamping the wafer W, so that the wafer W is forcibly brought into close contact with the substrate supporting member 3, thereby maintaining the closed space Sa on the back side of wafer.

When initially adjusting the gas flow rate, the air valves 22, 27, 31 are set to their open states at first. Also, the input switch 39 is turned on, so as to set the auxiliary air valve 33 to its open state, and the auxiliary air valve 32 to its closed state. Further, the MFC 29 is actuated. As a consequence, N₂ gas is supplied to the space Sb on the wafer surface side within the process chamber 2. N₂ gas is also supplied to the closed space Sa on the back side of wafer, whereby a process atmosphere is formed within the process chamber 2. Here, since the inside of the closed space Sa on the back side of wafer is kept in a substantially closed state due to the self weight of the wafer W and the like, there is substantially no gas leaking from within the closed space Sa on the back side of wafer to the space Sb on the wafer surface side.

While the value detected by the MFM 35 is being monitored, the flow rate of the gas discharged from the closed space Sa on the back side of wafer is controlled by the needle valve 30 such that the flow rate of the gas supplied into the closed space Sa on the back side of wafer is lower than the flow rate of the gas discharged from the closed space Sa on the back side of wafer. As a consequence, N₂ gas within the space Sb on the wafer surface side flows into the closed space Sa on the back side of wafer by way of a slight gap formed between the substrate supporting member 3 and the wafer W, thereby making a closed space of a forcible fluid.

When the above-mentioned initial adjustment is completed, the input switch 39 is turned off, so as to set the auxiliary air valve 32 to its open state, and the auxiliary air valve 33 to its closed state, and heat treatment for an actual wafer W is executed. First, the wafer W to be treated is transferred into the process chamber 2 by a transfer robot (not depicted). At the lapse of time t₁ therefrom, the three support pins 8 are raised by the lift member 7 so as to lift the wafer W and mount it on the ring frame 6 of the substrate supporting member 3.

Thereafter, at the lapse of time t₂, the following heat treatment process is started. First, predetermined flow rate setting signals are sent from the control unit 38 to the MFCs 28, 29. Then, the oxygen-containing gas is supplied into the closed space Sa on the back side of wafer. Here, since the needle valve 30 is controlled such that the flow rate of the oxygen-containing gas supplied into the closed space Sa on the back side of wafer is lower than the flow rate of the gas discharged from within the closed space Sa on the back side of wafer, a part of N₂ gas within the space Sb on the wafer surface side is drawn into the closed space Sa on the back side of wafer. Consequently, O₂ gas within the closed space Sa on the back side of wafer hardly enters the space Sb on the wafer surface side. Though O₂ gas and N₂ gas in the oxygen-containing gas are supplied into the closed space Sa on the back side of wafer at the same time here, N₂ gas may be supplied at first and then O₂ gas after the lapse of a predetermined time.

Substantially at the same time when the above-mentioned process gas and oxygen-containing gas are supplied, the substrate supporting member 3 is driven by a driving means (not depicted) to revolve, thereby rotating the wafer W. Also, a plurality of heating lamps 9 are lit. As a consequence, the temperature of wafer W gradually rises from room temperature (25°C) as shown in Fig. 5. At the lapse of time t₃, the temperature of the wafer Wreathes about 750°C, whereby an oxidized film of silicon dioxide SiO₂ for suppressing the sublimation of silicon suboxide SiO, which is a naturally oxidized film, is formed on the back face of the wafer W. Thereafter, at the lapse of time t₄, the temperature of the wafer W reaches 1000°C.

Then, at the lapse of time t₅, the heat treatment process ends. Namely, the wafer W stops rotating. Also, flow rate zero signals are sent from the control unit 38 to the MFCs 28, 29, whereby the supply of oxygen-containing gas into the process chamber 2 is terminated. As a consequence, the temperature of the wafer Wgradually decreases to the transfer temperature (about 750°C). Thereafter, at the lapse of time t₆, the wafer W is taken out of the process chamber 2 by the transfer robot (not depicted).

If particles in the gas and the like attach to and deposit on the needle valve 30 in the foregoing heat treatment of wafer W, then the difference between the flow rate of the gas discharged from within the closed space Sa on the back side of wafer and the flow rate of the oxygen-containing gas supplied into the closed space Sa on the back side of wafer becomes lower than a predetermined value. As a result, there is a possibility of O₂ gas within the closed space Sa on the back side of wafer entering the space Sb on the wafer surface side. For preventing this from happening, the input switch 39 is periodically turned on, so that the gas discharged from within the closed space Sa on the back side of wafer travels through the MFM 35. In this case, the supply flow rate of the oxygen-containing gas is automatically controlled such that the difference between the flow rate of the gas discharged from within the closed space Sa on the back side of wafer and the flow rate of the oxygen-containing gas supplied into the closed space Sa on the back side of wafer becomes the predetermined value, whereby O₂ gas is kept from making a detour to the surface side of the wafer W.

The oxygen concentration required when supplying the oxygen-containing gas into the closed space Sa on the back side of wafer in the foregoing heat treatment by the heat treatment apparatus 1 will now be explained.

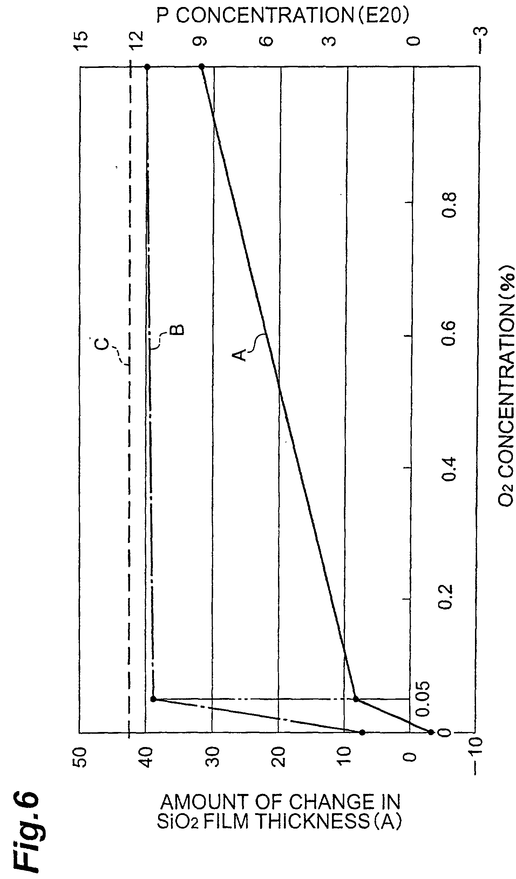

Fig. 6 shows an example of the relationships between the oxygen concentration in the gas within the closed space Sa on the back side of wafer and the phosphorus concentration within the wafer W and the film thickness of the oxidized film SiO₂ formed on the back face of the wafer W. In this graph, solid line A indicates the relationship between the oxygen concentration in the gas and the change in film thickness of the oxidized film SiO₂ formed on the back face of the wafer W (see the left-side ordinate). Dash-single-dot line B indicates the relationship between the oxygen concentration in the gas and the phosphorus concentration within the wafer W after heat treatment (see the right-side ordinate). Dotted line C in the graph indicates the phosphorus concentration within the wafer W before heat treatment (see the right-side ordinate). The oxygen concentration in the gas is that at 760 Torr, whereas the process time (time from the start of process until the end of process) is 60 seconds.

As can be seen from Fig. 6, the change in film thickness of oxidized film SiO₂ caused by heat treatment is -3.3 A (angstroms) when the oxygen concentration in the gas is zero. The phosphorus concentration within the wafer W after heat treatment is 2.19E20, whereby the amount of phosphorus corresponding to 10.01E20 is diffused from the wafer W to the outside upon heat treatment. When the oxygen concentration in the gas is 0.05% (500 ppm), the change in film thickness of oxidized film SiO₂ caused by heat treatment is 8.3 A, thus being greater than that in the case where no oxygen gas is added. Also, the phosphorus concentration within the wafer W after heat treatment is 11.7E20, whereby the amount of phosphorus diffusing from the wafer W to the outside upon heat treatment corresponds to 0.5E20, thus being much smaller than that in the case where no oxygen gas is added. When the oxygen concentration in the gas is 1%, the change in film thickness of oxidized film SiO₂ caused by heat treatment is 32 A, thus being further greater than that at the time when the oxygen concentration is 0.05%. The phosphorus concentration within the wafer W after heat treatment is 12.1E20, whereby the amount of phosphorus diffusing from the wafer W to the outside upon heat treatment is just slightly smaller than that at the time when the oxygen concentration is 0.05%.

According to the results mentioned above, the external diffusion of phosphorus caused by heat treatment is effectively suppressed when an oxygen-containing gas is supplied into the closed space Sa on the back side of wafer such that the oxygen concentration in the gas becomes 500 ppm or greater. If the oxygen concentration in the gas is too high, however, then there is a possibility of oxygen gas within the closed space Sa on the back side of wafer adversely affecting the surface processing of the wafer W when making a detour to the surface side of the wafer W. If the oxygen concentration in the gas is too low, on the other hand, there is a possibility of the film thickness of the oxidized film SiO₂ formed on the back face of the wafer W becoming so small that the diffusion suppressing effect cannot fully be exhibited. Therefore, in the example of Fig. 6, it is considered the most favorable to supply the oxygen-containing gas into the closed space Sa on the back side of wafer such that the oxygen concentration in the gas becomes about 500 ppm.

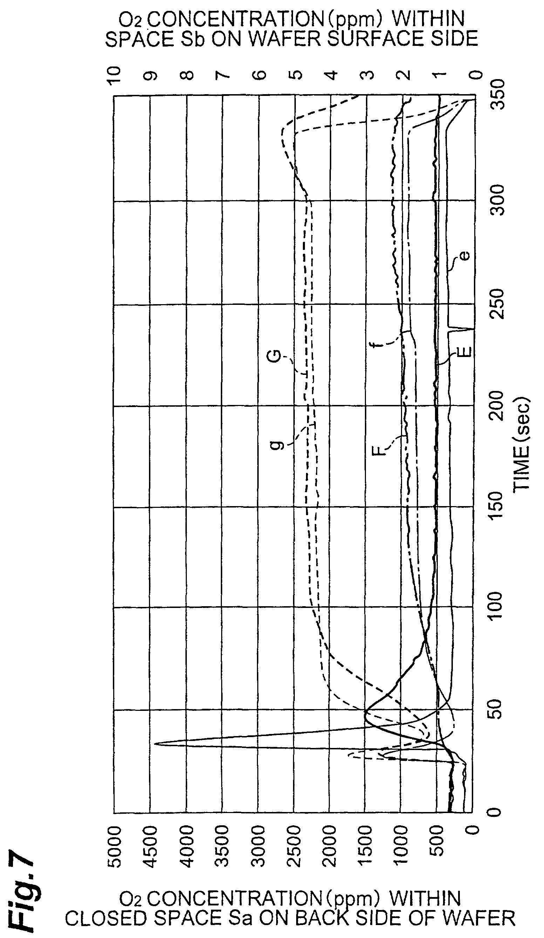

Fig. 7 shows an example of the relationship between the oxygen concentration in the gas within the closed space Sa on the back side of wafer and the oxygen concentration of the gas within the space Sb on the wafer surface side. In this graph, thinner solid line e indicates the oxygen concentration within the closed space Sa on the back side of wafer when the supply flow rate of oxygen gas is 1 sccm (see the left-side ordinate), whereas thicker solid line E indicates the oxygen concentration within the space Sb on the wafer surface side at this time (see the right-side ordinate). Thinner dash-single-dot line f indicates the oxygen concentration within the closed space Sa on the back side of wafer when the supply flow rate of oxygen gas is 2 sccm, whereas thicker dash-single-dot line F indicates the oxygen concentration within the space Sb on the wafer surface side at this time. Thinner dotted line g indicates the oxygen concentration within the closed space Sa on the back side of wafer when the supply flow rate of oxygen gas is 5 sccm, whereas thicker dotted line G indicates the oxygen concentration within the space Sb on the wafer surface side at this time. Here, the flow rate of nitrogen gas supplied into the closed space Sa on the back side of wafer is always 1 slm, the flow rate of the gas discharged from within the closed space Sa on the back side of wafer is always 2 slm, and the flow rate of nitrogen gas (process gas) supplied into the space Sb on the wafer surface side is always 10 slm.

As can be seen from Fig. 7, when the supply flow rate of oxygen gas is 2 sccm, for example, the oxygen concentration in the gas within the closed space Sa on the back side of wafer is 800 ppm (see thinner line f) in a steady state after the heating lamps 9 are lit, while the oxygen concentration in the gas within the space Sb on the wafer surface side is held at 2 ppm or less (see thicker line F). Therefore, when oxygen gas is added such that the oxygen concentration in the gas within the closed space Sa on the back side of wafer becomes 500 ppm as mentioned above, the oxygen concentration in the gas within the space Sb on the wafer surface side is held at 2 ppm or less, which hardly adversely affects the heat treatment for the wafer W at such a degree.

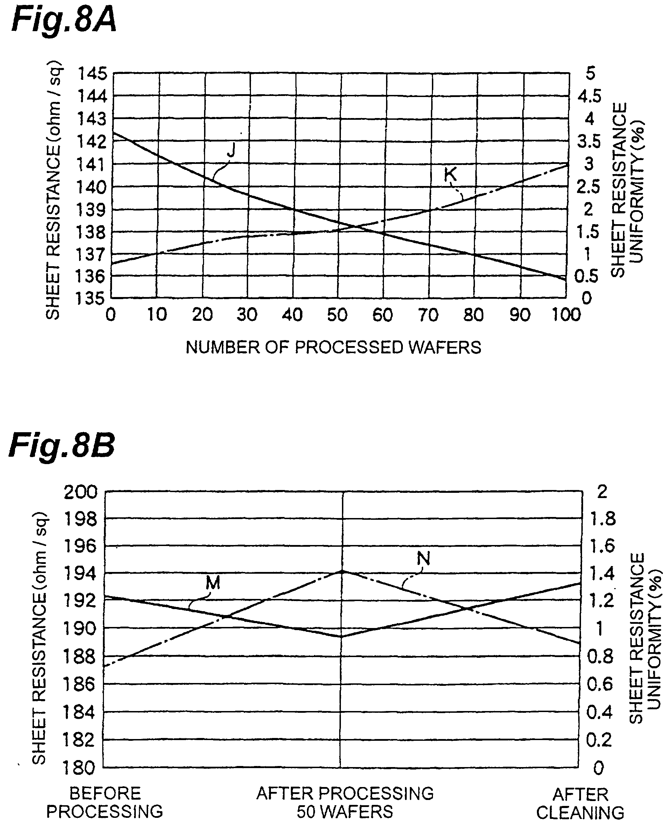

Figs. 8A and 8B show examples of sheet resistance characteristic of wafers W and its uniformity characteristic when oxygen gas is added and not added into the closed space Sa on the back side of wafer at the time of heat treatment, respectively. Here, Fig. 8A shows the characteristics obtained when no oxygen gas is added, whereas Fig. 8B shows the characteristics obtained when oxygen gas is added.

In Fig. 8A, solid line J indicates the number of processed wafers W and the sheet resistance of wafer W at this time (see the left-side ordinate), whereas dash-single-dot line K indicates the number of processed wafers W and the uniformity of sheet resistance of wafer W at this time (see the right-side ordinate). Here, the pressure within the process chamber 2 is 765 Torr, the process temperature is 1000°C, the process time is 10 seconds, and the flow rate of nitrogen gas supplied into the space Sb on the wafer surface side is 5 slm. Also, as ion implantation conditions for the wafer W, the dopant is BF₂, the acceleration voltage is 20 kV, and the dose is 5E15 atms/cm².

When no oxygen gas is added into the closed space Sa on the back side of wafer, the dopant added for controlling the resistance of the wafer W occurs from the back face of the wafer W. Also, the suboxide of silicon SiO on the back face of the wafer W sublimes. Also, it has been verified that these diffused materials attach to and deposit on the base section 2a of the process chamber 2, the substrate supporting member 3, the terminals of temperature sensors 10, and the like. Along therewith, a process shift in which the sheet resistance of wafers W and its uniformity gradually decrease is seen as shown in Fig. 8A, whereby the deviation of sheet resistance at the point in time when 50 sheets of wafers W are processed is specifically ±1.42%.

In Fig. 8B, on the other hand, solid line M indicates the number of processed wafers W and the sheet resistance of wafer W at this time (see the left-side ordinate), whereas dash-single-dot line N indicates the number of processed wafers W and the uniformity of sheet resistance of wafer W at this time (see the right-side ordinate). Here, the process temperature is 1000°C, the process time is 10 seconds, the flow rate of nitrogen gas supplied into the space Sb on the wafer surface side is 5 slm, the flow rate of oxygen gas supplied into the closed space Sa on the back side of wafer is 1 sccm, the flow rate of nitrogen gas supplied into the closed space Sa on the back side of wafer is 1 slm, and the oxygen concentration in the gas within the closed space Sa at this time is 450 ppm. Also, as ion implantation conditions for the wafer W, the dopant is boron (B), the acceleration voltage is 5 kV, and the dose is 1E15 atms/cm².

At the point in time when 50 sheets of wafers W are heat-treated in the case where oxygen gas is added into the closed space Sa on the back side of wafer, diffused materials occurring from the back side of the wafer W are hardly seen to adhere to the base section 2a of the process chamber 2, the substrate supporting member 3, the terminals of temperature sensors 10, and the like, whereby the inside of the closed space Sa on the back side of wafer is kept in a clean state. Also, as shown in Fig. 8B, the decrease in sheet resistance of wafers W and its uniformity upon heat treatment of the wafers W is suppressed. Specifically, the deviation of sheet resistance at the point in time when 50 sheets of wafers W are processed is ±0.35%, thus being greatly improved as compared with the case where no oxygen gas is added.

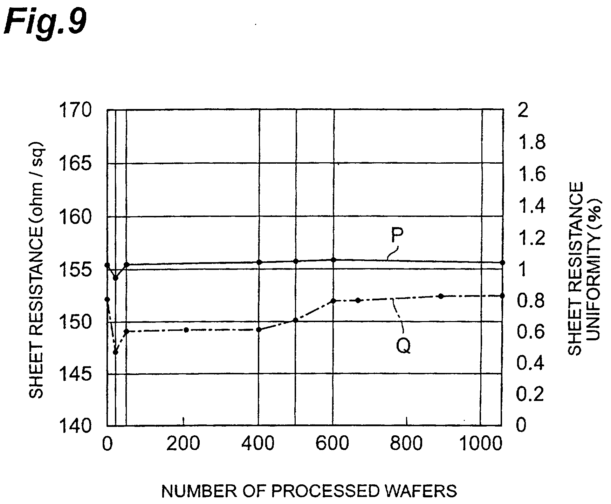

Fig. 9 shows an example of sheet resistance characteristic of wafers W and its uniformity characteristic when 1000 wafers W are heat-treated in a state where oxygen gas is added into the closed space Sa on the back side of wafer. In this graph, solid line P indicates the number of processed wafers W and the sheet resistance of wafer W at this time (see the left-side ordinate), whereas dash-single-dot line Q indicates the number of processed wafers W and the uniformity of sheet resistance of wafer W at this time (see the right-side ordinate). Here, the process temperature is 1000°C, the process time is 10 seconds, the flow rate of nitrogen gas supplied into the space Sb on the wafer surface side is 10 slm, the flow rate of oxygen gas supplied into the closed space Sa on the back side of wafer is 2 sccm, the flow rate of nitrogen gas supplied into the closed space Sa on the back side of wafer is 1 slm, and the discharging flow rate of the gas passing through the MFM 35 is 3 slm. Also, as ion implantation conditions for the wafer W, the dopant is BF₂, the acceleration voltage is 10 kV, and the dose is 1E15 atms/cm².

As can be seen from Fig. 9, the deviation of sheet resistance at the time when 1000 sheets of wafers W are processed is ±3% (see solid line P), whereby a stable state is maintained even after such a large number of wafers W are processed.

In this embodiment, as in the foregoing, oxygen gas is supplied into the closed space Sa on the back side of wafer at the time of heat-treating the wafer W, so that the back face of the wafer W is modified, whereby external diffusion from the back face of the wafer W such as the sublimation of SiO or occurrence of a dopant is suppressed. Therefore, diffused materials are suppressed from attaching to and depositing on the base section 2a of the process chamber 2, the terminals of temperature sensors 10, and the like. Consequently, the measurement system for controlling the temperature of the wafer W becomes stable, and the reproducibility of temperature improves, whereby the stability of process improves. Also, since the inside of the closed space Sa on the back side of wafer is kept in a clean state, dust is restrained from occurring. As a consequence, particles are less likely to occur, whereby the yield improves.

Also, the needle valve 31 or MFC 28, 29 is operated such that the flow rate of the gas discharged from within the closed space Sa on the back side of wafer is higher than the flow rate of the oxygen-containing gas supplied into the closed space Sa on the back side of wafer. As a consequence, oxygen gas within the closed space Sa on the back side of wafer is prevented from entering the space Sb on the wafer surface side and thereby adversely affecting the surface processing of the wafer W, whereby the atmosphere control for the surface of wafer W is maintained stably.

Here, the gas discharge system 19 is provided with two routes of discharge lines, so that the exhaust gas from within the closed space Sa on the back side of wafer does not travel by way of the filter 34 and MFM 35 at the time of normal heat treatment. As a consequence, the filter 34 and MFM 35 elongate their lives, thus making it unnecessary to replace them frequently.

Also, the oxygen concentration in the gas within the closed space Sa on the back side of wafer and the oxygen concentration in the gas within the space Sb on the wafer surface side are monitored by the concentration sensors 36, 37, and the process is forced to stop automatically when at least one of these oxygen concentrations deviates from their corresponding standards. Therefore, the oxygen concentration in the gas is prevented from becoming so high that the surface processing for the wafer W is adversely affected thereby or so low that the oxidized film SiO₂ formed on the back face of the wafer W becomes too thin.

Further, since the gas inlet 16 and the gas outlet 17 are disposed in the base section 2a of the process chamber 2 such that the sensor installation region is held therebetween, blockages existing at the terminal parts of individual temperature sensors 10, if any, are caused to flow out together with the oxygen-containing gas, so as to be discharged from the gas outlet 17. Therefore, the stability in temperature detection by the temperature sensors 10 improves.

Though a preferred embodiment of the present invention is explained in the foregoing, the present invention is not restricted thereto as a matter of course. For example, though oxygen gas for forming the oxidized film SiO₂ on the back face of wafer W is used as the modified layer forming gas in the above-mentioned embodiment, a gas for forming a nitride film or oxynitride film on the back face of wafer W may also be used. Examples of such a gas include ammonia gas (NH₃ gas) for forming SiNₓ, nitrogen monoxide gas (NO gas) and dinitrogen oxide gas (N₂O gas) for forming SiOₓN_{y}, and the like. Also, while a mixed gas of oxygen gas and nitrogen gas is used as the gas supplied into the closed space Sa on the back side of wafer, it is not restrictive in particular, so that a mixed gas of a modified film forming gas such as oxygen gas and an inert gas such as Ar gas may be used as well.

Though the gas discharge system 19 is provided with the needle valve 31, and the gas supply system 18 is provided with the MFCs 28, 29 in the above-mentioned embodiment, one of the needle valve 31 and MFC 28, 29 may be provided alone. Also, such means is not particularly necessary when the oxygen-containing gas within the closed space Sa on the back side of wafer hardly leaks into the space Sb on the wafer surface side due to the self weight of the wafer W or the like. Though the opening and closing of the auxiliary air valves 32, 33 are switched by the input switch 39, they may manually be switched without providing such input switch 39. While the gas discharge system 19 is provided with two routes of discharge lines, a single discharge line may be used as well. Further, though the oxygen concentration in the gas within the closed space Sa on the back side of wafer and the oxygen concentration in the gas within the space Sb on the wafer surface side are monitored by the concentration sensors 36, 37, it is not always necessary to provide two pieces of such concentration sensors, and they may be omitted as the case may be.

Though the above-mentioned embodiment explains a heat treatment apparatus, the present invention is also applicable to semiconductor fabrication apparatus such as CVD apparatus and the like as long as a substantially closed space is formed on the back side of a substrate when the substrate is supported by a substrate supporting member therein. Here, as long as a closed space can be formed on the back side of the substrate, the pressure within the process chamber can be reduced in a vacuum, or in a normal pressure state or a pressurized state (e.g., 800 Torr).

### Industrial Applicability

Since the second gas containing a modified layer forming gas is supplied into a closed space separately from the first gas after a substrate is supported by a substrate supporting member, the back face of the substrate is modified in accordance with the present invention. Consequently, the external diffusion from the back face of the substrate is reduced, whereby the amount of diffused material attaching to and depositing on wall sections of the process chamber and various measurement systems become smaller. Therefore, the measurement systems for controlling the temperature of the substrate are stabilized, the temperature reproducibility in heat treatment conditions becomes better, whereby the stability of the process improves. Also, the inside of the process chamber is kept in a clean state, and foreign matters are restrained from occurring.

## Claims

1. A substrate heating method in a semiconductor fabrication apparatus comprising a process chamber, a substrate supporting member installed within said process chamber so as to support a substrate, and a heating member for heating said substrate supported by said substrate supporting member, a substantially closed space being formed on the back side of said substrate when said substrate is supported by said substrate supporting member; said method including:
a step of supplying a first gas to the outside of said closed space within said process chamber after said substrate is supported by said substrate supporting member;
a step of supplying a second gas containing a modified layer forming gas for forming a modified layer on the back face of said substrate into said closed space after said substrate is supported by said substrate supporting member; and
a step of causing said heating member to heat said substrate supported by said substrate supporting member.

2. A substrate heating method according to claim 1, wherein, when supplying said second gas into said closed space, said second gas is supplied such that the flow rate of said second gas supplied into said closed space is lower than the flow rate of the gas discharged from within said closed space.

3. A substrate heating method according to claim 1, wherein, when supplying said second gas into said closed space, the flow rate of the gas discharged from within said closed space is detected, and the difference between the flow rate of the gas discharged from within said closed space and the flow rate of said second gas supplied into said closed space is adjusted so as to fall within a predetermined range.

4. A substrate heating method according to claim 1, wherein the concentration of said modified layer forming gas in the gas discharged from within said closed space is detected, and the heating of said substrate is stopped when the concentration of said modified layer forming gas does not fall within a predetermined range.

5. A substrate heating method according to claim 1, wherein the concentration of said modified layer forming gas in the gas discharged from outside said closed space within said process chamber is detected, and the heating of said substrate is stopped when the concentration of said modified layer forming gas exceeds a predetermined value.

6. A substrate heating method according to claim 1, wherein O₂ gas is used as said modified layer forming gas, and an oxidized layer is formed as said modified layer.

7. A substrate heating method according to claim 1, wherein one of NH₃ gas, NO gas, and N₂O gas is used as said modified layer forming gas, so as to form a nitride film or oxynitride film as said modified layer.

8. A substrate heating method according to claim 1, wherein a gas containing said modified layer forming gas and said first gas is used as said second gas.

9. A substrate heating method according to claim 1, wherein a gas containing said modified layer forming gas and N₂ gas is used as said second gas.

10. A substrate heating method according to claim 1, wherein said semiconductor fabrication apparatus is a heat treatment apparatus.

11. A substrate heating method in a semiconductor fabrication apparatus comprising a process chamber, a substrate supporting member installed within said process chamber so as to support a substrate, heating means for heating said substrate supported by said substrate supporting member, and sensor means for detecting a temperature of said substrate by utilizing a substantially closed space formed on the back side of said substrate when said substrate is supported by said substrate supporting member; said method including:
a step of forming said closed space by causing said substrate supporting member to support said substrate introduced into said process chamber; and
a step of supplying a gas containing a modified layer forming gas for forming a modified layer on the back face of said substrate into said closed space.

12. A semiconductor fabrication apparatus comprising a process chamber, a substrate supporting member installed within said process chamber so as to support a substrate, and heating means for heating said substrate supported by said substrate supporting member, a substantially closed space being formed on the back side of said substrate when said substrate is supported by said substrate supporting member; said apparatus comprising:
first gas supplying means for supplying a first gas to the outside of said closed space within said process chamber; and
second gas supplying means for supplying a second gas containing a modified layer forming gas for forming a modified layer on the back face of said substrate into said closed space.

13. A semiconductor fabrication apparatus according to claim 12, wherein said second gas supplying means has valve means for adjusting the flow rate of the gas discharged from within said closed space.

14. A semiconductor fabrication apparatus according to claim 12, wherein said second gas supplying means has supply flow rate control means for controlling the flow rate of said second gas supplied into said closed space.

15. A semiconductor fabrication apparatus according to claim 14, further comprising flow rate detecting means for detecting the flow rate of the gas discharged from within said closed space, and means for controlling said supply flow rate control means according to a value detected by said flow rate detecting means such that the difference between the flow rate of said gas discharged from within said closed space and the flow rate of said second gas supplied into said closed space falls within a predetermined range.

16. A semiconductor fabrication apparatus according to claim 15, wherein said second gas supplying means has a first open/close valve for turning on/off the flow of said gas discharged from within said closed space; a second open/close valve, connected in parallel with said first open/close valve, for turning on/off the flow of the gas discharged from within said closed space; said flow rate detecting means being connected in parallel with said first open/close valve on the downstream side of said second open/close valve.

17. A semiconductor fabrication apparatus according to claim 16, further comprising setting means for setting the opening/closing of said first and second open/close valves such that one of said first and second open/close valves is in an open state when the other is in a closed state.

18. A semiconductor fabrication apparatus according to claim 12, further comprising means for detecting the concentration of said modified layer forming gas in the gas discharged from within said closed space, and means for determining according to thus detected value whether the concentration of said modified layer forming gas is within a predetermined range or not and, when it is determined that said concentration is not within said predetermined range, outputting a process stop signal.

19. A semiconductor fabrication apparatus according to claim 12, further comprising means for detecting the concentration of said modified layer forming gas in the gas discharged from outside said closed space within said process chamber, and means for determining according to thus detected value whether the concentration of said modified layer forming gas exceeds a predetermined value or not and, when it is determined that the concentration exceeds said predetermined value, outputting a process stop signal.

20. A semiconductor fabrication apparatus according to claim 12, further comprising display means for displaying a processing state.

21. A semiconductor fabrication apparatus according to claim 12, wherein said process chamber has a base section forming a part of said closed space and having a sensor installation region in which a sensor is installed; and
wherein said second gas supplying means has a gas inlet, disposed in said base section, for supplying said second gas into said closed space, and a gas outlet, disposed in said base section, for discharging said second gas from within said closed space, said sensor installation region being disposed between said gas inlet and said gas outlet.

22. A semiconductor fabrication apparatus comprising:
a process chamber;
a substrate supporting member installed within said process chamber so as to support a substrate;
heating means for heating said substrate supported by said substrate supporting member;
sensor means for detecting a temperature of said substrate by utilizing a substantially closed space formed on the back side of said substrate when said substrate is supported by said substrate supporting member; and
gas supplying means for supplying a gas containing a modified layer forming gas for forming a modified layer on the back face of said substrate into said closed space.
